Europäisches Patentamt

European Patent Office

Office européen des brevets

(19)

(11) Publication number: **0 212 677 B1**

## EUROPEAN PATENT SPECIFICATION

(12)

(45) Date of publication of patent specification: **06.11.91**

(51) Int. Cl.5: **H03K 17/64**, H01H 47/32

(21) Application number: 86112771.0

(60) Publication number of the earlier application in accordance with Art.76 EPC: **0 083 996**

(22) Date of filing: **13.01.83**

(54) Electronic switching device with exciting coil.

(30) Priority: **13.01.82 JP 4172/82**

(43) Date of publication of application:
**04.03.87 Bulletin 87/10**

(45) Publication of the grant of the patent:
**06.11.91 Bulletin 91/45**

(84) Designated Contracting States:
**DE FR GB IT**

(56) References cited:
**DE-B- 1 129 529**
**FR-A- 1 434 429**
**FR-A- 2 144 430**

(73) Proprietor: **OMRON TATEISI ELECTRONICS CO.**
**10, Tsuchido-cho Hanazono Ukyo-ku**
**Kyoto-shi Kyoto-fu(JP)**

(72) Inventor: **Ohashi, Takeo**
**31-6-202, Yamadaminami**
**Suita-shi, Osaka(JP)**

(74) Representative: **Arthur, Bryan Edward**
**Withers & Rogers 4 Dyer's Buildings Holborn**
**London EC1N 2JT(GB)**

EP 0 212 677 B1

## Description

This invention relates to an electronic switching device, and more particularly to an improved electronic switching device employing an electromagnetic switch for switching a load connected thereto.

There is well known in the control system field an electronic switching device which includes an electromagnetic switch and an electronic circuit driving the electromagnetic switch, such as an electronic timer, an electronic counter, a photoelectric switch, a logic relay and so on. Such a conventional electronic switching device is designed such that the electronic circuit, in response to an external input signal applied thereto or an internally developed signal, energises the electromagnetic switch so as to close or open its normally-opened or -closed contacts which are connected to a load to be switched. In order to keep the electromagnetic switch, e.g. an electromagnetic relay, in such a closed or opened position, the electronic circuit must continue to energise an exciting coil of the electromagnetic switch so as to close or open the contacts, which means that the energising coil consumes a relatively large electric power. Thus, the conventional device must be provided with a large electric power source, and is inappropriate as an energy saving type device.

FR-A-2 144 430 describes a device in accordance with the preamble of claim 1 In this device the power source must be on whenever the device is to be switched. In order to overcome this disadvantage the present invention is characterised by the features set out in the characterising clause of claim 1.

Other advantageous features are set out in the dependent claims.

The switch may be a polarised electromagnetic relay employing a permanent magnet, or a stepping relay, and so forth. The invention allows the electromagnetic switch to be actuated to a set or a reset position by a momentary application of power from the capacitor, whereby the power source for the device can be reduced to such a small power capacity that it charges the capacitor with a relatively low current for a predetermined charging time duration, with the result that the power consumption of the electronic switching device is reduced.

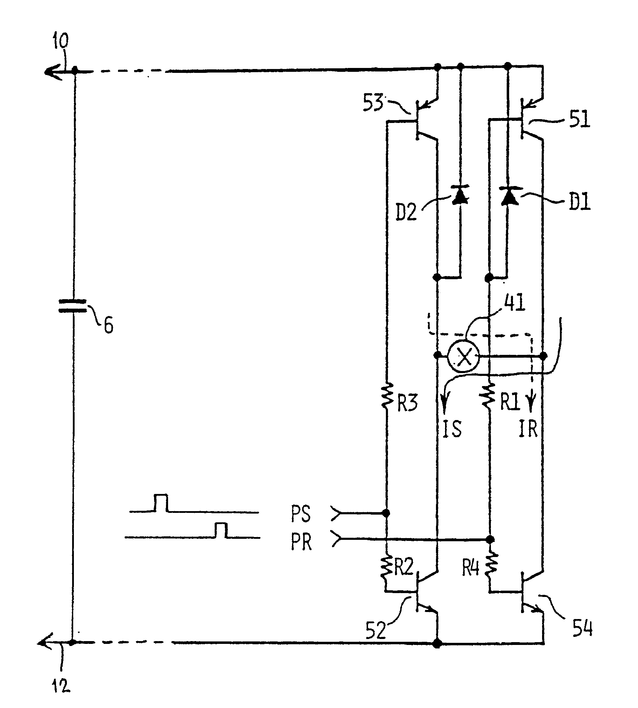

The invention will now be described by way of example with reference to the accompanying drawing which is a schematic circuit diagram of part of an electronic switching device in accordance with the invention.

Referring to the drawing, a preferred electronic switching device in accordance with the invention has two conductors 10,12 for connection via a current regulating resistance circuit (not shown) to a low capacity d.c. power source (also not shown). The circuitry shown in the drawing may form part of an electronic timer having means for generating switching pulses on a pair of control lines which would be connected to the inputs PS and PR of the circuit. The circuit is arranged such that a first pulse applied to the input PS of the circuit causes current to flow in one direction through the coil 41 of a self-latching electromagnetic switch so as to set the switch, while a subsequent second pulse applied to the input PR causes a reverse current to flow through the coil 41 so as to reset the self latching electromagnetic switch.

This is achieved by means of four transistors 51,52,53 and 54 and a capacitor 6 connected between the conductors 10 and 12 as shown in the drawing.

The four transistors comprise a pair of set switching transistors 51 and 52 and a pair of reset switching transistors 53 and 54. As is apparent from the drawing, when a set pulse PS, e.g. of duration 10 ms, is applied to the circuit, a set current IS flows through transistors 51 and 52. Similarly, when a reset pulse PR, e.g. of duration 10 ms, is applied to the circuit, a reset current IR flows through transistors 53 and 54. Thus, positive and negative discharging currents IR and IS from the capacictor 6 are alternately applied to the coil 41 so as to set and reset the electromagnetic switch, respectively.

The electromagnetic switch, including the coil 41, is preferably a relay of the latching type which is set by a positive current and reset by a negative current through the coil 41. The relay may be a polarised relay employing a permanent magnet.

In operation, when the d.c. power source is coupled (via a relatively high impedance) to the conductors 10 and 12, the capacitor is charged. At each setting or resetting operation, power is discharged momentarily from the capacitor 6 to drive the coil 41. Since the total energy for setting and resetting the relay is supplied from the capacitor 6, which is fully charged with a small current through the resistance (not shown) from the power source and consumed on setting or resetting the relay, a reduced power source may be employed and no energy is needed to keep the relay in a set or reset position.

The resistance coupled between the power source and the conductors 10,12 may be a switching regulator having a low impedance (e.g. 20 ohms) to be powered by an unstable external power source, e.g. varying between 12V and 240V, and to generate a predetermined regulated voltage, e.g. 5V. The regulator may, however, be of relatively small capacity, e.g. capable of generating a 10 mA output current in spite of a large current relay circuit requiring e.g. a 100 mA exciting current.

Instead of a switching regulator, a d.c./d.c. convertor may be employed.

## Claims

1. An electronic switching device comprising a circuit having an electromagnetic coil (41), and a driver circuit comprising first (53, 52) and second (51, 54) switching means each comprising two transistors, each switching means (53, 52, 51, 54) being connected to a respective terminal of the coil (41) and being operable to connect said terminal selectively to one or other terminal (10, 12) of a voltage source (6), and control means for generating first and second control signals (PS, PR) for the first and second switching means (53, 52, 51, 54) such that current is supplied to the coil (41) in one direction in response to the first control signal (PS) and in the opposite direction in response to the other control signal (PR), characterised in that the voltage source is a capacitor (6) connected across the combination of a small capacity source, including current regulating means, for charging the capacitor in the absence of control pulses (PS, PR), in that the circuit is a self-latching bi-stable relay circuit, and in that the switching means (53, 52, 51, 54) are so connected to the said coil (41) that the application of the first control signal in the form of a single first control pulse to the switching means causes a momentary discharge of power from the capacitor (6) as current through the coil (41) in the said one direction, and that the application of the second control signal in the form of a single second control pulse to the switching means causes another momentary discharge of power as current through the coil (41) in the said opposite direction, the switching means being substantially non-conductive in the absence of the said control pulses, and the power source and regulating means being of relatively small capacity in terms of the currents which the momentary capacitor discharges produce in the coil (41).

2. A driver circuit according to claim 1, characterised in that the first control pulse (PS) is applied to the bases of the two transistors (53, 52) of the first switching means, the capacitor (6) discharging through a transistor (51) of the second switching means, the coil (41) and a transistor (52) of the first switching means which is set to a conducting state by the first control pulse (PS), the other transistor (53) of the first switching means being set to a non-conducting state by the first control pulse (PS).

3. A driver circuit according to claim 1 or 2, characterised in that the second control pulse (PR) is supplied to the bases of the two transistors (51, 54) of the second switching means, the capacitor (6) discharging through a transistor (53) of the first switching means, the coil (41) and a transistor (54) of the second switching means which is set to a conducting state by the second control pulse (PR), the other transistor (51) of the second switching means being set to a non-conducting state by the second control signal (PR).

## Revendications

1. Dispositif électronique de commutation comprenant un circuit à bobine électromagnétique (41), et un circuit de commande comprenant des premiers (53, 52) et seconds (51, 54) moyens de commutation possédant chacun deux transistors, chaque moyen de commutation (53, 52, 51, 54) étant relié respectivement à une borne de la bobine (41) et étant utilisable pour connecter sélectivement ladite borne à l'une ou l'autre borne (10, 12) d'une source de tension (6), et un moyen de commande pour produire un premier signal et un second signal de commande (PS, PR) pour les premiers et les seconds moyens de commutation (53, 52, 51, 54) de sorte que le courant est appliqué à la bobine (41) dans un sens en réponse au premier signal de commande (PS) et dans le sens opposé en réponse à l'autre signal de commande (PR), caractérisé en ce que la source de tension est un condensateur (6) connecté aux bornes d'une combinaison formée d'une source de petite capacité et d'un un moyen de régulation du courant, pour charger le condensateur en l'absence des impulsions de commande (PS, PR), en ce que le circuit est un circuit de relais bi-stable à auto-verrouillage, et en ce que les moyens de commutation (53, 52, 51, 54) sont connectés d'une manière telle à ladite bobine (41) que l'application du premier signal de commande sous la forme d'une première impulsion de commande unique au moyen de commutation entraîne une décharge momentanée de l'énergie du condensateur (6) en tant que courant à travers la bobine (41) dans ledit premier sens, et en ce que l'application du second signal de commande sous la forme d'une seconde impulsion de commande unique au moyen de commutation provoque une autre décharge momentanée de l'énergie en tant que courant à travers la bobine (41) dans ledit sens opposé, le moyen de commutation étant pratiquement non conducteur en l'absence des-dites impulsions de commande, et la source de puissance et le moyen de régulation étant de capacité relativement faible en fonction des courants que les décharges momentanées du condensateur produisent dans la bobine (41).

2. Circuit de commande selon la revendication 1, caractérisé en ce que la première impulsion de commande (PS) est appliquée aux bases des deux transistors (53, 52) du premier moyen de commutation, le condensateur (6) se déchargeant à travers un transistor (51) du second moyen de commutation, la bobine (41) et un transistor (52) du premier moyen de commutation qui est placé à l'état conducteur par la première impulsion de commande (PS), l'autre transistor (53) du premier moyen de commutation passant à l'état bloqué par la première impulsion de commande (PS).

3. Circuit de commande selon la revendication 1 ou 2, caractérisé en ce que la seconde impulsion de commande (PR) est appliquée aux bases des deux transistors (51, 54) du second moyen de commutation, le condensateur (6) se déchargeant à travers un transistor (53) du premier moyen de commutation, la bobine (41) et un transistor (54) du second moyen de commutation qui est rendu conducteur par la seconde impulsion de commande (PR), l'autre transistor (51) du second moyen de commutation passant à l'état bloqué par le second signal de commande (PR).

**Patentansprüche**

1. Elektronische Schaltvorrichtung, bestehend aus einem Schaltkreis mit einer elektromagnetischen Wicklung (41), einem Steuerkreis, der aus einem ersten (53, 52) und einem zweiten (51, 54) Schaltelement besteht, wobei jedes Schaltelement aus zwei Transistoren besteht, die Schaltelemente (53, 52, 51, 54) jeweils mit der betreffenden Anschlußklemme der Wicklung (41) verbunden sind und in der Lage sind, die Anschlußklemmen wahlweise mit der einen oder anderen Anschlußklemme einer Spannungsquelle (6) zu verbinden, und Kontrollelementen zur Erzeugung des ersten und zweiten Kontrollsignals (PS, PR) für das erste und zweite Schaltelement (53, 52, 51, 54), so daß die Spule (41) in einer Richtung als Antwort auf das erste Kontrollsignal (PS) und in die andere Richtung als Antwort auf das andere Kontrollsignal (PR) mit Strom versorgt ist, **dadurch gekennzeichnet,** daß die Spannungsquelle ein Kondensator (6) ist, der über eine Quelle geringerer Kapazität geschaltet ist, die mit Stromregelelementen ausgestattet ist, um den Kondensator in Abwesenheit der Steuerimpulse (PS, PR) zu laden, daß der Stromkreis ein selbstverriegelnder bistabiler Relaisstromkreis ist, die Schaltelemente (53, 52, 51, 54) so mit der besagten Spule (41) verbunden sind, daß das Anlegen eines ersten Steuersignals in Form eines einzelnen ersten Kontrollimpulses an das Schaltelement eine momentane Entladung des Kondensators (6) und einen Stromfluß durch die Spule in die besagte eine Richtung bewirkt, und das Anlegen des zweiten Steuersignals in Form eines einzelnen zweiten Kontrollimpulses an das Schaltelement eine momentane Entladung des Kondensators (6) und einen Stromfluß durch die Spule in die besagte andere Richtung bewirkt, das Schaltelement in der Abwesenheit des besagten Kontrollimpulses nicht leitend ist und daß die Energiequelle und das Regelelement eine relativ geringe Kapazität entsprechend den Strömen, die die momentane Kondensatorentladung in der Spule (41) erzeugt, besitzen.

2. Steuerkreis nach Anspruch 1, **dadurch gekennzeichnet,** daß der erste Kontrollimpuls (PR) an die Basis der beiden Transistoren (53, 52) des ersten Schaltelementes angelegt wird, der Kondensator (6) durch einen Transistor (51) des zweiten Schaltelementes entladen wird, die Spule (41) und ein Transistor (52) des ersten Schaltelementes durch den ersten Kontrollimpuls (PS) leitend gemacht werden und der andere Transistor (53) des ersten Schaltelementes durch den ersten Kontrollimpuls (PS) in einen nicht leitenden Zustand versetzt wird.

3. Steuerkreis nach Anspruch 1 oder 2, **dadurch gekennzeichnet,** daß der zweite Kontrollimpuls (PR) an die Basis der beiden anderen Transistoren (51, 54) des zweiten Schaltelementes gesendet wird, der Kondensator (6) des ersten Schaltelementes durch einen Transistor (53) entladen wird, die Spule (41) und ein Transistor (54) des zweiten Schaltelementes durch den zweiten Kontrollimpuls (PR) in leitenden Zustand versetzt werden und der andere Transistor (51) des zweiten Schaltelementes durch das zweite Kontrollsignal (PR) in einen nicht leitenden Zustand versetzt wird.